Europäisches Patentamt

European Patent Office

Office européen des brevets

(11) Numéro de publication : **0 060 743**
**B1**

# FASCICULE DE BREVET EUROPÉEN

(45) Date de publication du fascicule du brevet : 26.06.85

(51) Int. Cl.⁴ : **H 01 L 31/10**

(21) Numéro de dépôt : 82400309.9

(22) Date de dépôt : 22.02.82

(54) Photodétecteur sensible dans l'infra-rouge proche.

(30) Priorité : 10.03.81 FR 8104712

(43) Date de publication de la demande : 22.09.82 Bulletin 82/38

(45) Mention de la délivrance du brevet : 26.06.85 Bulletin 85/26

(84) Etats contractants désignés : DE GB NL

(56) Documents cités :
EP-A- 0 045 258
FR-A- 2 096 539
FR-A- 2 336 804
EXTENDED ABSTRACTS, volume 79-2, "Fall meeting" 14-19 octobre 1979 PRINCETON N.J. (US) S.P. TOBIN et al. Experimental determination of minority carrier properties and recombination mechanism in P Hg1-xCdxTe (0,2 kleiner oder gleich an x kleiner oder gleich an 0,4)

(73) Titulaire : **SOCIETE ANONYME DE TELECOMMUNI-CATIONS**
**40 avenue de New York**
**F-75116 Paris (FR)**

(72) Inventeur : **Pichard, Guy**
**4, Villa Provence**
**F-94430 Chennevières (FR)**
Inventeur : **Royer, Michel**
**29, rue Claude Decaen**
**F-75012 Paris (FR)**

(74) Mandataire : **Bloch, Robert et al**
**39 avenue de Friedland**
**F-75008 Paris (FR)**

## Description

La présente invention concerne un photodétecteur dont la sensibilité maximale se situe au voisinage de 1,3 μm, comprenant un substrat de type P en $Hg_{1-x}Cd_xTe$, et une zone dopée de type N formée sur le substrat, la jonction résultante étant du type P-N.

Dans les photodétecteurs, il peut être souhaitable que le temps de réponse soit le plus court possible, en particulier lorsque l'on utilise de tels détecteurs pour détecter les signaux lumineux transmis par fibres optiques, le débit numérique dans ce type de liaisons étant extrêmement élevé.

On sait d'autre part que l'atténuation dans la transmission par fibres optiques est minimale pour deux valeurs de la longueur d'onde du signal transmis, à savoir 1,3 μm et 1,6 μm.

On connaît déjà, par le document EP-A-0 045 258, compris dans l'état de la technique selon l'article 54.3, des photodétecteurs qui, par l'emploi d'un substrat de type P en $Hg_{1-x}Cd_xTe$, possèdent un temps de réponse très court et sont sensibles aux longueurs d'onde ci-dessus, la fraction molaire x étant choisie à l'intérieur d'une plage allant de 0,4 à 0,9, en fonction de la longueur d'onde à recevoir.

Cependant, de tels photodétecteurs ne fournissent pas nécessairement, d'une part, un courant de sortie important et, d'autre part, un rapport signal/bruit très élevé. En d'autres termes, l'intensité lumineuse passant dans les fibres optiques étant faible, le gain en courant des détecteurs, c'est-à-dire le rapport, à une longueur d'onde donnée, entre le courant électrique créé et l'intensité lumineuse reçue, peut ne pas être suffisant.

On connaît le procédé qui pallie partiellement cet inconvénient et consistant à polariser en inverse le photodétecteur, sous une forte tension, afin de placer son point de fonctionnement dans la région d'avalanche.

En effet, cette polarisation élevée est possible du fait que la jonction utilise un substrat très faiblement dopé, et a donc une capacité faible, si bien que la constante de temps, ou le temps de réponse, du détecteur est faible surtout aux tensions inverses importantes.

Cependant, un inconvénient de ce procédé est que le point de fonctionnement, du fait de cette polarisation inverse élevée, est proche de la tension d'avalanche non contrôlée, autrement dit de la tension de claquage de la jonction.

D'autre part, cette tension de polarisation inverse, de l'ordre de quelques dizaines ou centaines de volts, est fournie par une alimentation plus ou moins complexe ou coûteuse nécessitant une source d'énergie.

La présente invention vise à pallier ces lacunes et à proposer un photodétecteur ayant un gain important, et pouvant par conséquent fonctionner sous une tension de polarisation inverse faible.

A cet effet, la présente invention concerne un photodétecteur en $Hg_{1-x}Cd_xTe$ du type mentionné ci-dessus, caractérisé par le fait que x a une valeur sensiblement égale à 0,67.

On sait que de tels photodétecteurs présentent le phénomène selon lequel la réponse spectrale, et plus précisément la longueur d'onde de coupure, dépend de x.

Ainsi, la valeur de x étant déjà a priori imposée par le choix de la longueur d'onde désirée, il aurait pu paraître vain de rechercher si un autre phénomène, dépendant lui aussi de la valeur de x, ne pouvait pas être à l'origine d'un courant électrique de sortie plus important.

Et c'est ainsi que la demanderesse a quand même recherché si le gain en courant, autrement dit le facteur de mérite de la jonction, ne dépendrait pas avantageusement lui aussi de x. Non seulement la demanderesse a mis en évidence ce phénomène, à savoir que le facteur de mérite, dont la valeur entraîne celle du courant de sortie, dépendrait effectivement de la fraction molaire x, mais elle a encore constaté que la valeur de x, propice à un courant plus important, était très proche de celle optimisant la détection d'une certaine longueur d'onde.

Plus particulièrement, la demanderesse a montré que le facteur de mérite, et donc le courant de sortie, atteignait son maximum pour une valeur de x voisine de 0,67 mais différente de celle qui correspond à la détection optimale, à temps de réponse court, d'un rayonnement de longueur d'onde de 1,3 μm.

L'invention sera bien comprise à la lecture de la description suivante d'un mode de réalisation préféré, faite en référence aux dessins annexés sur lesquels :

Les figures 1 à 7 illustrent les différentes phases du procédé de fabrication du photodétecteur selon l'invention.

La figure 8 représente les courbes de réponse spectrale du détecteur selon l'invention, pour plusieurs valeurs de la polarisation inverse.

La figure 9 représente, d'une part, la courbe de la longueur d'onde de coupure et, d'autre part, la valeur du facteur de mérite, fonctions de la fraction molaire du substrat du détecteur selon l'invention, et

la figure 10 représente la courbe du gain en courant du détecteur selon l'invention en fonction de la tension de polarisation inverse, pour la valeur choisie de x.

Le détecteur représenté est bien adapté pour une longueur d'onde voisine de 1,3 μm. Il comporte un substrat constitué d'un alliage de mercure, de cadmium et de tellure, $Hg_{1-x}Cd_xTe$, dans lequel la fraction molaire x est comprise entre 0,4 et 0,9 comme indiqué dans le document EP-A-0 045 258.

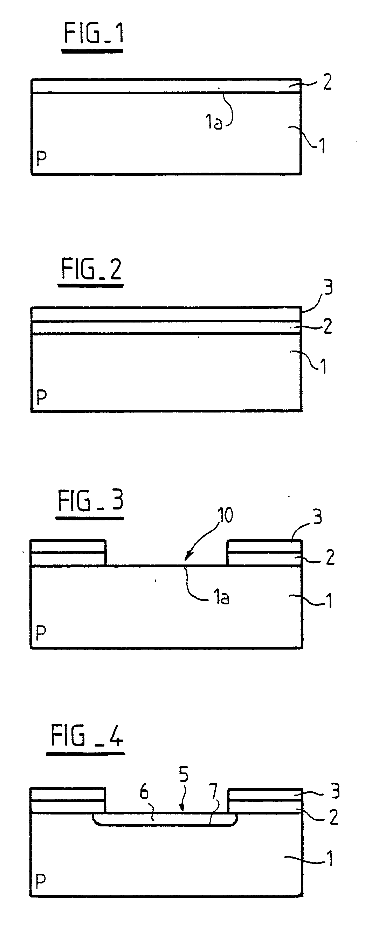

Pour fabriquer le détecteur de l'invention, on part d'un substrat 1 de type P (cf. fig. 1), formé d'un cristal de $Hg_{1-x}Cd_xTe$ de très haute pureté, présentant donc une concentration en porteurs P très faible, de l'ordre de $10^{15}/cm^3$. Un tel cristal peut être obtenu par exemple, par la méthode décrite dans un article de R. Triboulet, intitulé « Cd Te and Cd Te : Hg alloys cristal growth using stoichiometric and off-stoichiometric zone passing techniques », paru dans la Revue de Physique Appliquée, de février 1977.

Sur le substrat 1, on dépose une couche 2 de Cd Te, par exemple par pulvérisation cathodique. Puis on dépose sur la couche 2 une couche de masquage 3 (fig. 2), de préférence en ZnS, SiO ou $SiO_2$. On réalise ensuite au moins une ouverture 10 dans les couches 2 et 3, de façon à mettre à nu une partie de la surface 1a du substrat 1 (fig. 3). Ensuite, on réalise une jonction planar PN par une première diffusion dans le substrat 1 d'un élément tel que le cadmium ou le mercure ou d'une impureté telle que l'aluminium, l'indium, ou le bore (flèche 5, fig. 4).

On obtient ainsi une zone 6 de type N, de dopage d'environ $10^{16}$ atomes/cm³, qui forme avec le substrat P une jonction 7.

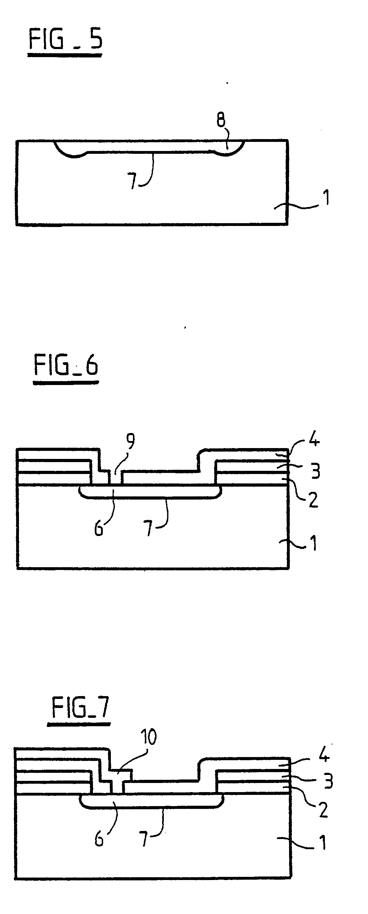

Cependant, dans le but de diminuer la courbure de cette jonction 7 à ses extrémités, et donc de réduire la valeur du champ électrique, et par conséquent le risque de claquage dans ces régions, on peut réaliser dans les mêmes conditions une diffusion préalable d'un des mêmes éléments selon la technique dite à anneau de garde (fig. 5), pour obtenir finalement une zone 8 de type N à plus grande courbure.

Un autre procédé utilisable pour former la zone N est l'implantation ionique d'atomes possédant, après un recuit approprié, une activité électrique de type N, tels que des atomes d'indium In, d'aluminium Al ou de bore B.

On dépose ensuite une couche 4 de même nature que la couche 3 sur toute la surface puis on pratique une ouverture 9 dans la couche 4, fig. 6, par attaque chimique, et on remplit cette ouverture avec un métal conducteur, tel que Al ou In, afin de réaliser un contact 10 (fig. 7).

Le détecteur décrit ci-dessus est utilisé comme détecteur de rayonnement dans l'infra-rouge proche.

Le choix de la valeur de la fraction molaire x repose sur les considérations suivantes.

Pour définir la structure des bandes électroniques, on peut utiliser le modèle à bande de conduction, bande interdite et bande de valence.

L'arrivée d'un photon du rayonnement reçu crée, si son énergie est suffisante, une paire électron-trou qui participe à un courant proportionnel au flux incident.

On comprend bien que lorsque la longueur d'onde $\lambda$ du rayonnement dépasse un certain seuil, l'énergie des photons, proportionnelle à $1/\lambda$, n'est plus suffisante pour créer des paires électrons-trous.

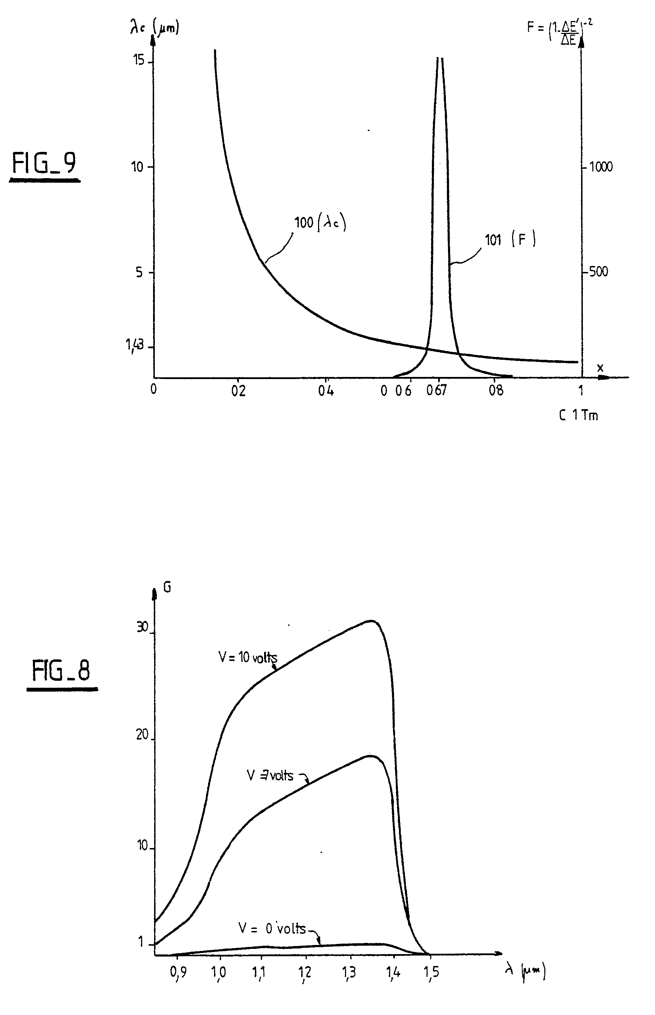

C'est pourquoi, pour une valeur de x donnée, c'est-à-dire pour une valeur $\Delta E$ donnée de la largeur de la bande interdite, il existe une longueur d'onde de coupure $\lambda_c$, telle que, lorsque le rayonnement a une longueur d'onde $\lambda > \lambda_c$, aucun courant n'est créé dans la jonction, ce qui explique l'aspect des courbes de la fig. 8, qui représentent la réponse S du détecteur, c'est-à-dire le rapport G entre le courant créé et l'intensité lumineuse reçue, en fonction de la longueur d'onde $\lambda$ du rayonnement reçu, et ce pour trois valeurs de la tension de polarisation V de la jonction, et une valeur de x déterminée. On note que dans l'exemple de la figure 8, le gain en courant est déjà important pour une polarisation inverse faible.

La courbe 100 de la fig. 9 représente la longueur d'onde de coupure $\lambda_c$ en fonction de x, en $\mu m$.

Ainsi pour recevoir de façon optimale un rayonnement de longueur d'onde 1,3 $\mu m$, la longueur d'onde de coupure doit être supérieure à 1,3 $\mu m$, mais de préférence assez voisine comme l'indiquent les courbes de réponse spectrale (fig. 8).

Ainsi pour détecter un rayonnement d'une longueur d'onde de 1,3 $\mu m$, qui correspond à un minimum d'atténuation dans les fibres optiques, la valeur optimale de x se situerait au voisinage de 0,7, au vu de la courbe 100 de la fig. 9. Cependant l'inconvénient précédemment cité, à savoir le faible courant de sortie du détecteur, ne serait pas pour autant forcément résolu.

Or il existe, dans la structure des bandes électroniques du semi-conducteur envisagé, une autre bande, dite bande de Spin-orbite.

On a trouvé que la différence d'énergie $\Delta E'$ entre la bande de Spin-orbite et la bande de valence était susceptible, suivant sa valeur, de jouer un rôle en ce qui concerne les générations-recombinaisons d'électrons-trous créés par les photons. Plus particulièrement, pour une large gamme de valeurs de x, $\Delta E'$ est 5 à 10 fois plus grand que $\Delta E$ et, dans ce cas, la bande de Spin-orbite n'a que peu d'influence sur les générations-recombinaisons des électrons-trous. Cependant pour certaines valeurs de x, entre environ 0,6 et 0,8, la valeur de $\Delta E'$ est assez proche de celle de $\Delta E$, toutes deux ayant pour ordre de grandeur 0,9 eV. On conçoit que les propriétés de création et de recombinaison des paires électron-trou vont être alors sensiblement différentes de celles correspondant au modèle qui ne tient pas compte de la bande de Spin-orbite.

Le phénomène est le suivant. Lorsque la bande de Spin-orbite n'a pas d'influence, ou peu d'influence sur le phénomène photoélectrique, il se crée, par le rayonnement reçu, un courant d'électrons et un courant de trous, sensiblement égaux, c'est-à-dire des coefficients d'ionisation $\alpha$ et $\beta$ de valeurs sensiblement égales.

Cependant lorsque x se situe dans une plage s'étendant de 0,6 à 0,8 environ, l'influence de la bande de Spin-orbite est réelle et l'on obtient des coefficients d'ionisation $\alpha$ et $\beta$ très différents. En effet, le rapport $\beta/\alpha$ est proportionnel au terme $F = (1 - (\Delta E'/\Delta E)^{-2}$, appelé facteur de mérite, illustré par la courbe 101 de la fig. 9, qui représente la valeur du facteur de mérite F en fonction de la composition du substrat, c'est-à-dire de x. On constate que cette valeur passe par un maximum pour une valeur de x sensiblement égale à 0,67 et qu'elle est supérieure à 10 lorsque x est compris entre 0,55 et 0,85. Les valeurs de $\alpha$ et $\beta$ sont alors très différentes, le gain en courant en fonction de la tension de polarisation est mieux contrôlé et le rapport signal/bruit est plus élevé.

Il faut donc choisir d'une part une valeur de x telle que le facteur de mérite et par conséquent le courant de sortie soient importants, et d'autre part une valeur de x optimisant la réception d'un rayonnement de longueur d'onde 1,3 $\mu$m, valeur optimale pour une transmission par fibre optique.

Les deux valeurs de x les plus satisfaisantes, l'une pour le courant, l'autre pour la longueur d'onde, sont différentes.

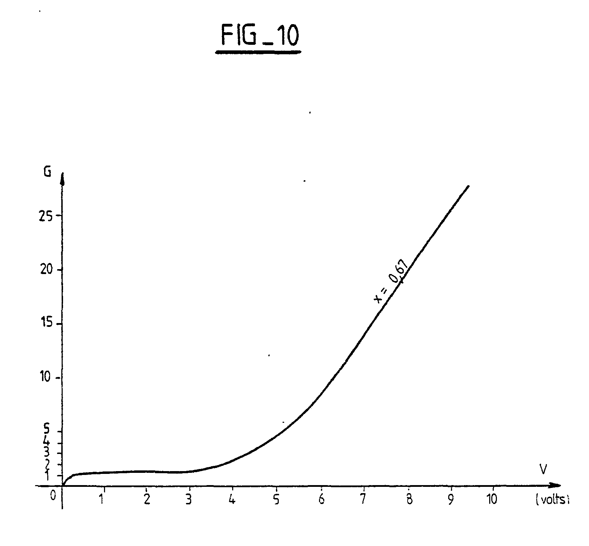

La présente invention concerne donc un détecteur capable à la fois de détecter un rayonnement de longueur d'onde de 1,3 $\mu$m et de fournir un courant de sortie important, c'est-à-dire ayant un gain en courant important, sans pour autant devoir appliquer une tension de polarisation inverse importante. Cette caractéristique se retrouve d'ailleurs sur la courbe de la fig. 10, représentant le gain G défini plus haut, fonction de la tension de polarisation inverse V, pour la valeur de x choisie. On constate que ce gain commence à augmenter pour une tension d'environ − 4 ou − 5 volts, pour atteindre une valeur de 30, plus que satisfaisante, pour une valeur de V de l'ordre de − 10 volts, considérée comme faible.

Pour x = 0,67, qui correspond donc à un gain maximal, la longueur d'onde de coupure $\lambda_c$ est égale à 1,43 $\mu$m, longueur qui convient parfaitement pour la réception d'un rayonnement de longueur d'onde de 1,3 $\mu$m.

Les caractéristiques du photodétecteur sont avantageusement les suivantes :

Surface sensible : $1 \times 10^{-4}$ cm²
Tension de polarisation inverse V : 10 volts
Gain en courant G : 30
Courant de saturation : < 1 nA
Courant d'obscurité (V = − 10$^V$) : < 10 nA
Capacité totale (V = − 10$^V$) < 1 pF
Capacité de jonction (V = − 10$^V$) < 0,2 pF
Produit résistance surface (V = ov) : $6 \times 10^4 \, \Omega \times$ cm²
Réponse en courant ($\lambda$ = 1,3 $\mu$m) : > 0,5 A/w.
Température de fonctionnement : 300 °K.

## Revendications

1. Photodétecteur ayant sa sensibilité maximale au voisinage de 1,3 $\mu$m, comprenant un substrat de type P en Hg$_{1-x}$Cd$_x$Te, et une zone dopée de type N formée sur le substrat, la jonction résultante étant du type P-N, caractérisé par le fait que x a une valeur sensiblement égale à 0,67.

2. Photodétecteur selon la revendication 1, caractérisé par le fait que le substrat a une concentration en porteurs P inférieure à 10$^{15}$/cm³.

3. Photodétecteur selon l'une des revendications 1 et 2, caractérisé par le fait que la zone N est formée par au moins une diffusion thermique de cadmium, ou de mercure, ou d'aluminium ou d'indium, ou de bore.

4. Photodétecteur selon la revendication 3, caractérisé par le fait que la zone N est formée par deux diffusions thermiques.

5. Photodétecteur selon l'une des revendications 1 et 2, caractérisé par le fait que la zone N est formée par implantation ionique d'indium, d'aluminium ou de bore.

6. Photodétecteur selon l'une des revendications 1 à 5, caractérisé par le fait qu'il est polarisé avec une tension de − 10 volts.

## Claims

1. Photodetector having its maximum sensivity in the neighbourhood of 1.3 $\mu$m, comprising a P type substrate of Hg$_{1-x}$Cd$_x$Te, and a doped N-type zone formed on the substrate, the resulting junction being of the P-N type, characterized in that x has a value substantially equal to 0.67.

2. Photodetector according to claim 1, characterized in that the substrate has a concentration of P carriers less than 10$^{15}$/cm³.

3. Photodetector according to one of claims 1 and 2, characterized in that the N zone is formed by at least one thermal diffusion of cadmium, or mercury, or aluminium, or indium or boron.

4. Photodetector according to claim 3, characterized in that the N zone is formed by two thermal diffusions.

5. Photodetector according to one of claims 1 and 2, characterized in that the N zone is formed by ionic implantation of indium, aluminium or boron.

6. Photodetector according to one of claims 1 to 5, characterized in that it is biased with a voltage of − 10 volts.

## Patentansprüche

1. Photodetektor, der seine maximale Sensibilität in der Nähe von 1,3 $\mu$m hat, bestehend aus einem Trägermaterial vom Typ P aus Hg$_{1-x}$Cd$_x$Te und einer auf das Trägermaterial aufgebrachten dotierten Zone vom Typ N, wobei der resultierende Übergang vom Typ P-N ist, dadurch gekennzeichnet, daß x einen Wert von im wesentlichen gleich 0,67 hat.

2. Photodetektor nach Anspruch 1, dadurch gekennzeichnet, daß das Trägermaterial eine Konzentration von P-Ladungsträger von weniger als 10$^{15}$/cm³ hat.

3. Photodetektor nach Anspruch 1 und 2, dadurch gekennzeichnet, daß die N-Zone durch mindestens eine Thermodiffusion von Cadmium oder Quecksilber oder Aluminium oder Indium oder Bor gebildet ist.

4. Photodetektor nach Anspruch 3, dadurch gekennzeichnet, daß die N-Zone durch mindestens zwei Thermodiffusionen gebildet ist.

5. Photodetektor nach einem der Ansprüche 1 und 2, dadurch gekennzeichnet, daß die N-Zone durch Ionenimplantation von Indium, Aluminium oder Bor gebildet ist.

6. Photodetektor nach einem der Ansprüche 1 bis 5, dadurch gekennzeichnet, daß er mit einer Spannung von − 10 Volt polarisiert ist.

## FIG_1

P  1a  2  1

## FIG_2

P  3  2  1

## FIG_3

P  10  3  2  1a  1

## FIG_4

P  5  6  7  3  2  1

FIG _ 5

FIG_ 6

FIG_ 7

# 0 060 743

FIG_9

FIG_8

3

## FIG _ 10